# EUROPEAN PATENT SPECIFICATION

(11) **EP 0 305 589 B1**
(45) Date of publication and mention of the grant of the patent: **17.12.1997**
(21) Application number: 87116747.4
(22) Date of filing: 04.10.1983
(51) Int. Cl.: H01L 23/48, H01L 21/56

(54) **Method and apparatus for the encapsulation of a semiconductor device mounted on a lead-frame**
Verfahren und Apparat zur Einkapselung einer auf einem Leiterrahmen montierten Halbleitervorrichtung
Procédé et appareil pour l'encapsulation d'un dispositif semi-conducteur monté sur un cadre de connexion

(30) Priority: 04.10.1982 US 432594
(43) Date of publication of application: 08.03.1989
(62) Divisional of application: 83305898.5
(73) Proprietor: TEXAS INSTRUMENTS INCORPORATED, Dallas Texas 75265 (US)
(72) Inventor: Orcutt, John W., Galand Texas (US)
(74) Representative: Abbott, David John

(56) References cited:
- EP-A- 0 007 762
- EP-B- 0 110 518
- DE-A- 2 150 432
- GB-A- 1 185 347
- US-A- 3 795 492
- US-A- 3 950 140
- US-A- 4 003 125
- PATENT ABSTRACTS OF JAPAN, vol. 6, no. 176 (E-130)[1054], 10th September 1982; & JP-A-57 93 557 (NIPPON DENKI K.K.) 10-06-1982
- IDEM

## Description

### BACKGROUND OF THE INVENTION

### Field of the Invention

This invention relates generally to the packaging of semiconductor devices and to lead frames for use in such packaging. More particularly, the invention relates to lead frames for use on and the packaging by encapsulation in a plastics material of semiconductor devices mounted upon the lead frame.

### Description of the Prior Art

It is known to encapsulate semiconductor devices, for example, Integrated Circuits, with plastic as shown in U.S. Patent No. 4,043,027 issued to Birchler et al on August 23, 1977 and entitled "Process for Encapsulating Electronic Components in Plastic". The semiconductor devices are first attached to the bar pad of a lead frame. Contact pads on the semiconductor device are then individually attached by wire bonding, for example ball bonding, to corresponding contact pads on the ends of leads of the lead frame adjacent to but spaced from the bar pad. The attachment of the semiconductor device can be by any standard technique for example by alloying the surface of the semiconductor away from the surface having the active circuits located thereon to a surface of the bar pad.

The lead frame which can be attached to a plurality of other similar lead frames is then placed in a mold. The mold is provided with a cull or reservoir containing a quantity of raw plastic. A network of runners or channels extend from the cull to one or more cavities containing the semiconductor devices. The path of the plastic from the cull to cavity may extend through one or more cavities. In general, a gate or constriction is provided in the runner immediately prior to the cavity. The lead frame is seated in a chase or depression in the mold. The mold is generally constructed in two parts. The lead frame is seated into a chase in one part of the mold utilizing alignment stubs extending from the chase. The alignment stubs have corresponding alignment holes in lead frame to ensure that the lead frame is properly seated into the chase. The other part of the mold is then brought into contact with the part having the lead frame seated therein. When properly aligned the semiconductor device is located in a cavity formed by depressions in both parts of the mold. The cavity is connected by a runner to the cull of the mold. Pressure is then applied to the plastic in the cull and forced under pressure through the runners into the cavity. The plastic encloses the semiconductor device, the bar pad of the lead frame, and the ends of the leads of the lead frame adjacent to the semiconductor device. The entire length of the wires individually connecting the contact pads of the semiconductor device and the contact pads on the ends of the leads of the lead frame adjacent to the semiconductor device are also enclosed. However, it should be noted that portions of the leads of the lead frame including the ends of the lead frame away from the semiconductor device are clamped between the two parts of the mold and are therefore outside the cavity. The portion of the lead frame outside the cavity is not enclosed by plastic. Heat is applied to the mold to cure the plastic to sufficient hardness. The mold is then opened and the lead frame removed. The operation is then repeated.

It has been found useful to form the lead frames in a strip. Each lead frame of a strip has a semiconductor device attached to its bar pad as discussed above. The bar pads are connected through supports to two parallel side rails. Each side rail is located in the plane of the lead frame and on opposite sides of the bar pad. The leads of each lead frame are formed into two sets extending generally parallel to the side rails from adjacent opposite sides of the bar pad. The leads of each lead frame are connected to the leads of at least one adjacent lead frame. Typically when the strip is placed into the chase of a mold, at least one other strip is placed into another similar chase of the mold. It is also known in the art to supply plastic to a cavity through another cavity. In the system, two lead frames are formed laterally adjacent between the side rails. The cavity of the lead frame adjacent the runner is connected to the cavity of the lead frame away from the runner.

The lead frames are constructed from a flat metal sheet by an etch technique or by a punch operation. After the encapsulated semiconductor device and lead frame are removed from the mold, they are generally placed in an oven for the application of heat to further cure the plastic. The individual leads are then separated. The leads are usually connected together to provide additional mechanical support during the assembly process and to provide a dam to prevent plastic from leaving the cavity between the leads. The support between the leads is outside the plastic encapsulating the semiconductor device and a portion of the lead frame. The separation of the leads is generally referred to as a trim operation. If the leads are in a strip, the leads are then severed from the leads of the adjacent lead frames. The side rails are also separated from the leads and from the supports attached to the bar pad within the encapsulating plastic. A unique electrical connection has bow been formed between the contact pads on the semiconductor device and the ends of the lead frame located outside the encapsulating plastic for the connection of the semiconductor device with other circuitry. For example, an electrical connection is formed from one contact pad on the semiconductor device through the wire attached thereto and the contact pad on the end of an adjacent lead to the end of the lead outside the encapsulating plastic.

In EP-A-0 007 762 there are described a method and an apparatus for encapsulating semiconductor devices in a plastics material. The devices on lead frames are held in cavities in a cavity plate with two separate mold plates placed one on each side of the cavity plate. The upper mold plate has open grooves acting as feed runners for feeding plastics material to the cavities when the apparatus is assembled, either directly through into the cavities or along grooves in the mating face of the cavity plate acting as sub-runners.

In US-A-3 795 492, there is described the encapsulation of semiconductor devices on a lead frame in a plastics material in which the devices and the lead frame are held between two mold halves. The mold halves have cavities for containing the semiconductor devices and for receiving the encapsulating plastics material. In the lead frame, supports are provided on which the semiconductor devices are mounted, which supports are surrounded by cut-away portions of the lead frame where the plastics encapsulations are formed. The cut-away portions include slots respectively extending to overlap the ends of closed branch leaders formed in one of the mold halves to permit the flow of the encapsulation material into the cavities. After molding at least parts of the slots will contain encapsulation material.

It is an object of the present invention to provide an improved lead frame and a method and apparatus for encapsulating a semiconductor device when received upon the lead frame.

### SUMMARY OF THE INVENTION

According to a first aspect of the present invention there is provided an apparatus for packaging semiconductor devices within encapsulating plastic enclosures in which a substantially flat metal strip including a plurality of lead frames is placed between two parts of a mold having cavities in each part respectively aligned with the lead frames, and a reservoir of encapsulating plastic under pressure is connected to the cavities by a main runner and sub-runners formed in the parts of the mold, each lead frame being provided with a bar pad having a semiconductor device attached thereto and with a plurality of leads, each lead extending from one end adjacent to the bar pad to an opposite end away from the bar pad, each cavity including the bar pad and the semiconductor device and a portion adjacent to the one end of each lead of the respective lead frame, wherein
the metal strip includes a thoroughfare in the form of a solid portion that extends from the main runner connected to the reservoir to said cavities, thereby forming one of the surfaces of the sub-runners, and
the sub-runners overlie the thoroughfare to convey fluid plastics material from the reservoir via the main runner over one surface of the strip to the cavities.

According to a second aspect of the present invention there is provided a method of encapsulating semiconductor devices within plastic enclosures comprising
providing a substantially flat metal strip including a plurality of lead frames, each lead frame being provided with a bar pad having a semiconductor device attached thereto and with a plurality of leads, each lead extending from one end adjacent to the bar pad to an opposite end away from the bar pad,
placing the metal strip between two parts of a mold having cavities in each part respectively aligned with the lead frames, each cavity including the bar pad and the semiconductor device and a portion adjacent to the one end of each lead of the respective lead frame, and
supplying encapsulating plastic in fluid form under pressure from a reservoir external to the mold to each cavity, wherein
the metal strip includes a thoroughfare in the form of a solid portion that extends from a main runner formed in the mold and connected to the reservoir and to said cavities, thereby forming one of the surfaces of the sub-runners, and
the encapsulating plastic is conveyed to the cavities along sub-runners in one part of the mold over one surface of the thoroughfare, the sub-runners extending from the runner to the cavities.

### BRIEF DESCRIPTION OF THE DRAWINGS

FIGURE 1 is a top view of a strip of lead frames;
FIGURE 2 is a top view of the strip of lead frames of Figure 1 after encapsulation;
FIGURE 3 is a top view of a plastic encapsulation apparatus;
FIGURE 4 is a cross-sectional view taken along line 4-4 of Figure 3;
FIGURE 5 is a side view of a strip of lead frames within a mold;

### DESCRIPTION OF THE PREFERRED EMBODIMENTS

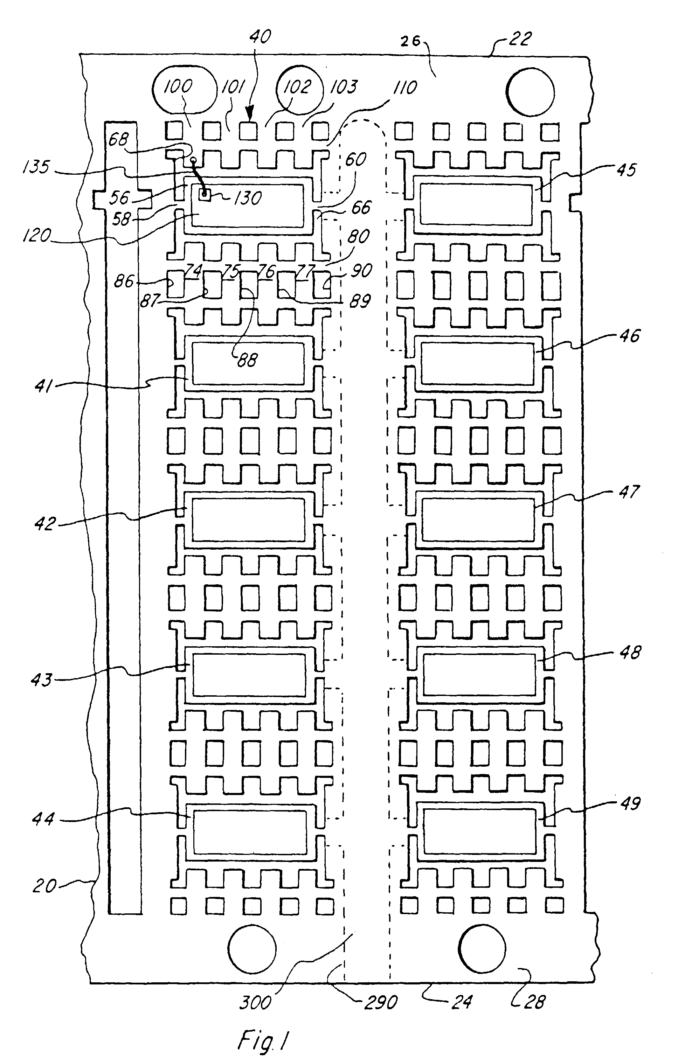

With reference to the drawings and in particular to Figure 1 thereof, a stip 20 is shown. Strip 20 is constructed from a flat sheet of metal for example stainless steel. The metal sheet has been etched or punched to produce the strip 20 with lead frames. Strip 20 has two longitudinal sides 22 and 24. The portions of strip 20 adjacent to longitudinal sides 22 and 24 form side rails 26 and 28, respectively. An opening 30 in strip 20 separates portions of the strip 20 which are connected only by side rails 26 and 28. Lead frames 40-49 are provided in strip 20. The other portions of strip 20 (not shown in Figure 1) can be provided with other lead frames. Although ten lead frames are shown in Figure 1 any convenient number can be provided. The lead frames 40-49 are similar and a detailed discussion of lead frame 40 shall suffice for all. Lead frame 40 has a bar pad 56 with a rectangular shape which is connected to lead frame 40 and therefore the major portion of strip 20 by supports 58 and 60. Lead frames 40 has openings 66 and 68. Opening 66 extends between bar pad 56, supports 58 and 60, and leads 74-77. Leads 74-77 extend from adjacent a side of bar pad 56 which is perpendicular to the sides having supports 58 and 60 attached thereto. The leads extend from their ends adjacent to bar pad 56 to other opposite ends away from bar pad 56. The leads 74-77 extend basically parallel. A lateral support 80 extends from the major portion of strip 20 across leads 74-77 to provide additional mechanical support during the assembly process and to act as a dam during encapsulation. Opening 66 is also bounded by lateral support 80. The smaller openings 86-90 extend between leads 74-77 and the lateral support 80. The end of leads 74-77 away from bar pad 56 are attached to the major portion of strip 20. Another set of leads 100-103 similar to leads 74-77 extends from ends adjacent a side of bar pad 56 away from the side of bar pad 56 to which an end of leads 74-77 is adjacent. A lateral support 110 is provided across leads 100-103 and is similar to lateral support 80. A semiconductor device 120 which may be an integrated circuit is attached to a flat surface of bar pad 56 by alloying for example. The semiconductor device 120 has a plurality of contact pads (only contact pad 130 is shown) which represent the input/output and power connections and which are connected by wires (only wire 135 is shown) to the ends of the leads 74-77 and 100-103 (only the contact pad on the end of lead 100 is shown connected through wire 135 to contact pad 130 of semiconductor device 120). The connection of wire 135 can be by any standard technique, for example ball bonding. Although eight leads are shown in Figure 1, any number of leads can be utilized with the present invention. In some cases, however, not all the contact pads on the device are connected to contact pads on the leads.

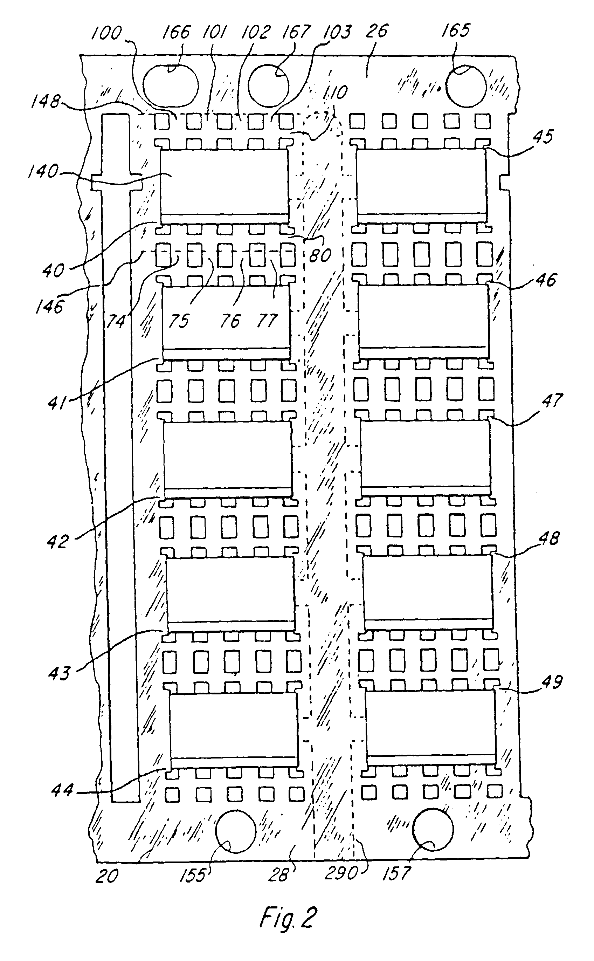

As shown in Figure 2, lead frame 40 is encapsulated with plastic forming an enclosure 140 which protects the connecting wires and the bonds to the pads. Within the enclosure 140 is semiconductor device 120, bar pad 56, supports 58 and 60, and the ends of leads 74-77 and 100-103 adjacent to bar pad 56 (Figure 1). Enclosure 140 protects the wire bonding and semiconductor device from contact. When desired, leads 74-77 and 100-103 are severed along dotted lines 146 and 148, respectively, and the lateral supports 80 and 110 are severed between the leads to produce isolated electrical connections between the leads and the contact pads on the semiconductor device 120. Thus, electrical connection between the semiconductor device 120 and other circuitry is possible. The other lead frames 41-49 are encapsulated in a similar manner.

Holes 155 and 157 are shown in side rail 28. Holes 165-167 are shown in side rail 26. Holes 155 and 165, and 157 and 167 are located at similar locations. However an additional hole 166 is provided in side rail 26 to prevent upside down insertion of the strip 20. The holes 155, 157, and 165-167 provide alignment information and allow easy indexing of the strip 20.

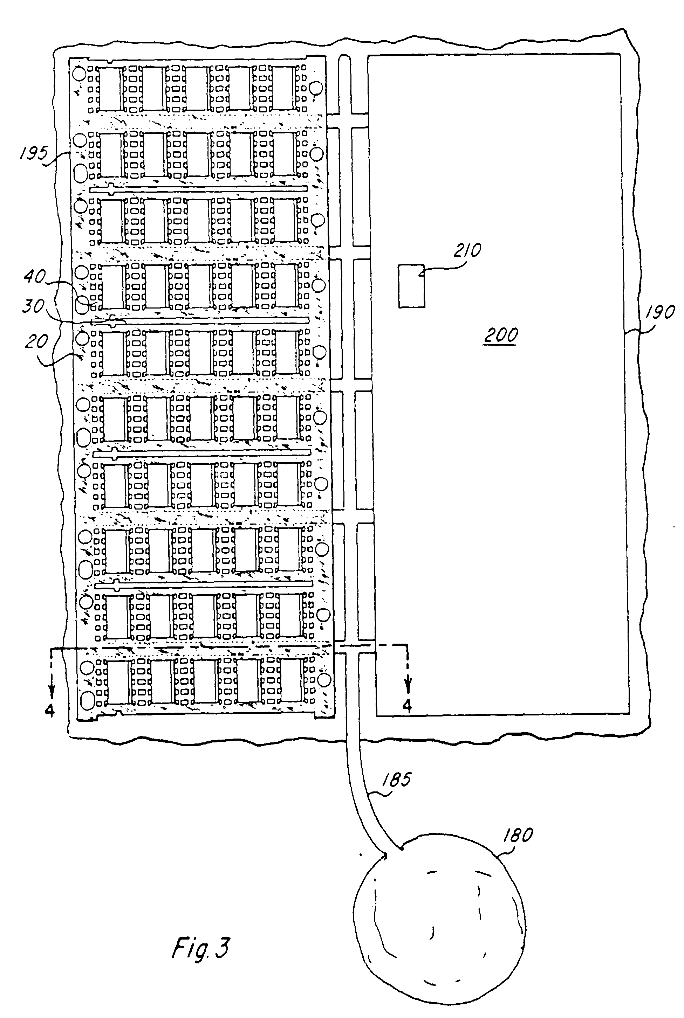

As shown in Figure 3, strip 20 has a number of openings similar to opening 30. The area between openings is similar to the area including lead frames 40-49 (Figure 1, only lead frame 40 shown in Figure 3).

As can be seen from Figures 1 and 2 adjacent vertical rows of lead frames are separated by a thoroughfare 300 comprising a solid (i.e. non-perforated) area of the strip 20. In Figure 3, the thoroughfares are horizontal and shown as dotted lines between adjacent horizontal rows of lead frames.

A cull 180 has a supply of plastic material therein. The cull 180 is connected through a main runner 185 into a mold 190. The mold 190 has strip 20 therein. The strip 20 is located in a chase 195 which aligns the strip and which is similar to chase 200. Chase 200 is adapted to receive and align a strip (not shown) which is similar to strip 20. A plurality of depressions in chase 200 (only depression 210 is shown) are located for the semiconductor devices, the bonding wires, and the portion of the leads adjacent the bar pad to be disposed therein. The depression is sufficiently deep to provide adequate spacing from and to prevent contact with the wires or the semiconductor device. In fact the depth of the depression is approximately half of the desired height of the enclosure. The chase 200 is itself a shallow depression adapted to receive a strip of lead frames similar to strip 20 is close fit. The other part of mold 190 is provided with depressions corresponding to for example depression 210 in chase 200. The combination of the depressions when the mold 190 is closed creates cavities having the shape and volume of enclosures 140 (Figure 2). When pressure is applied to the plastic in cull 180, it flows down main runner 185 and into subrunners described in detail below until it reaches the cavities where the semiconductor devices are located. U.S. Patent No. 4,043,027 issued to Birchler et al on August 23, 1977 and entitled "Process for Encapsulating Electronic Components in Plastic", which is incorporated by reference hereinto, discusses general molding techniques.

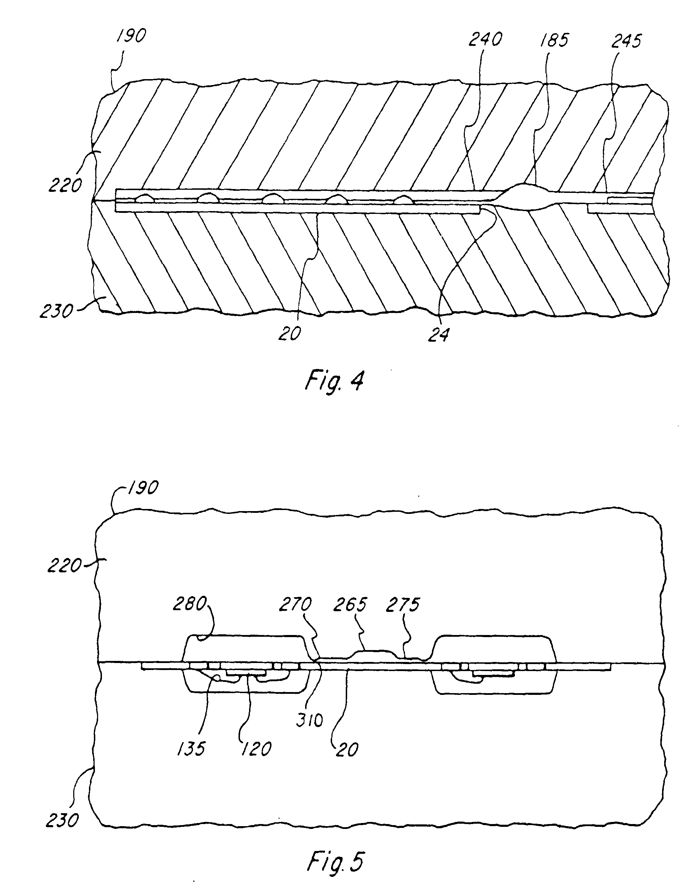

As shown in Figure 4, the mold 190 has an upper part 220 and a lower part 230. The subrunners 240 and 245 branch off perpendicularly from main runner 185. Subrunners 240 and 245 each feed five runners which connect the subrunners to the cavities wherein the semiconductor devices are located. It should be noted that the upper part 220 and the lower part 230 of mold 190 are held in close contact by pressure. It should be noted that the subrunner 245 only passes over the side 24 of strip 20 once. Thus only one discontinuity is presented to the flow of plastic along subrunner 245 and that is at the passage over side 24. This eliminates a major cause of contamination of the mold 19 from plastic not being firmly connected to the strip and breaking off in the mold.

As shown in Figure 5, a subrunner 265 branches off into runners 270 and 275. Runner 270 leads into the cavity 280 formed between parts 220 and 230 of mold 190. The plastic flows through runner 270 and into cavity 280. The lower portion of the cavity is filled by the plastic flowing through the openings 66, and 68 (Figure 1). The location of subrunner 265 is shown in Figure 1 by dotted line 290. The thoroughfares 300 between the rows of lead frames with one row formed by lead frames 40-44 and another row formed by lead frames 45-49 form one surface of the runner 265 and allows the plastic to pass over one surface of the strip until it reaches a cavity. A gate 310 is provided to allow easy separation of the enclosure 140 (Figure 2) and from the plastic filling runner 270 after the mold is opened and the plastic cured.

It will be appreciated that the thoroughfares form one of the surfaces of the runner along which the plastic passes and thus has the advantage of preventing plastic scrap being left in the mold, such scrap being carried out of the mold on the surface of the thoroughfare.

'Flash-over' which is defined as a discontinuity in the path of flow of the plastic is avoided. Such flash-over is undesirable because it allows plastic to enter areas where it is not desired and perhaps leave scrap in the mold after the strip is removed.

## Claims

1. An apparatus for packaging semiconductor devices within encapsulating plastic enclosures in which a substantially flat metal strip (20) including a plurality of lead frames (40-49) is placed between two parts (220,230) of a mold (190) having cavities (280) in each part respectively aligned with the lead frames, and a reservoir (180) of encapsulating plastic under pressure is connected to the cavities by a main runner (185) and sub-runners (240,245,265,270,275) formed in the parts of the mold, each lead frame being provided with a bar pad (56) having a semiconductor device (120) attached thereto and with a plurality of leads (74-77), each lead extending from one end adjacent to the bar pad to an opposite end away from the bar pad, each cavity (280) including the bar pad (56) and the semiconductor device (120) and a portion adjacent to the one end of each lead (74-77) of the respective lead frame, wherein
the metal strip includes a thoroughfare (300) in the form of a solid portion that extends from the main runner (185) connected to the reservoir (180) to said cavities, thereby forming one of the surfaces of the sub-runners, and
the sub-runners (240,245,265,270,275) overlie the thoroughfare (300) to convey fluid plastics material from the reservoir (180) via the main runner (185) over one surface of the strip (20) to the cavities (280).

2. Apparatus according to claim 1 wherein the metal strip includes lead frames on both sides of the thoroughfare.

3. A method of encapsulating semiconductor devices within plastic enclosures comprising
providing a substantially flat metal strip (20) including a plurality of lead frames (40-49), each lead frame being provided with a bar pad (56) having a semiconductor device (120) attached thereto and with a plurality of leads (74-77), each lead extending from one end adjacent to the bar pad to an opposite end away from the bar pad,
placing the metal strip between two parts (220,230) of a mold 190 having cavities (280) in each part respectively aligned with the lead frames, each cavity (280) including the bar pad (56) and the semiconductor device (120) and a portion adjacent to the one end of each lead (74-77) of the respective lead frame, and
supplying encapsulating plastic in fluid form under pressure from a reservoir (180) external to the mold to each cavity, wherein
the metal strip includes a thoroughfare (300) in the form of a solid portion that extends from a main runner (185) formed in the mold and connected to the reservoir (180) and to said cavities, thereby forming one of the surfaces of the sub-runners, and the encapsulating plastic is conveyed to the cavities along sub-runners (240,245,265,270,275) in one part of the mold over one surface of the thoroughfare, the sub-runners extending from the runner (185) to the cavities.

## Patentansprüche

1. Vorrichtung zum Einbauen von Halbleitervorrichtungen in einkapselnde Kunststoffgehäuse, in der ein im wesentlichen flacher Metallstreifen (20) mit mehreren Leiterrahmen (40 - 49) zwischen zwei Teile (220, 230) einer Form (190) gebracht wird, die in jedem Teil Ausnehmungen (280) enthält, die auf die Leiterrahmen ausgerichtet sind, und ein Reservoir (180) aus einkapselndem Kunststoff unter Druck mit den Ausnehmungen über einen Hauptangußkanal (185) und Nebenangußkanälen (240, 245, 265, 270, 275) verbunden wird, die in den Teilen der Form gebildet sind, wobei jeder Leiterrahmen mit einer Plättchenauflage (56), an dem eine Halbleitervorrichtung (120) befestigt ist, und mit mehreren Leitern (74 - 77) versehen ist, wobei jeder Leiter von einem an die Plättchenauflage angrenzenden Ende zu einem entgegengesetzten Ende, weg von der Plättchenauflage, verläuft, wobei jede Ausnehmung (280) die Plättchenauflage (56) und die Halbleitervorrichtung (120) sowie einen an ein Ende jedes Leiters (74 - 77) des entsprechenden Leiterrahmens angrenzenden Abschnitt enthält, bei welcher
der Metallstreifen einen Durchgangsweg (300) in Form eines festen Abschnitts aufweist, der von dem mit dem Reservoir (180) verbundenen Hauptangußkanal (185) zu den Ausnehmungen verläuft, so daß dadurch eine der Flächen der Nebenangußkanäle gebildet wird, und
die Nebenangußkanäle (240, 245, 265, 270, 275) über dem Durchgangsweg liegen, damit fließendes Kunststoffmaterial von dem Reservoir (180) über den Hauptangußkanal (185) über eine Fläche des Streifens (20) zu den Ausnehmungen (280) transportiert wird.

2. Vorrichtung nach Anspruch 1, bei welchem der Metallstreifen auf beiden Seiten des Durchgangswegs Leiterrahmen enthält.

3. Verfahren zum Einkapseln von Halbleitervorrichtungen in Kunststoffgehäuse, bei dem
ein im wesentlichen flacher Metallstreifen (20) mit mehreren Leiterrahmen (40 - 49) vorgesehen wird, wobei jeder Leiterrahmen mit einer Plättchenauflage (56), an der eine Halbleitervorrichtung (120) befestigt ist, und mehreren Leitern (74 - 77) versehen ist, wobei jeder Leiter von einem an die Plättchenauflage angrenzenden Ende zu einem entgegengesetzten Ende, weg von der Plättchenauflage, verläuft,
der Metallstreifen zwischen zwei Teilen (220, 230) einer Form (190) mit Ausnehmungen (280) in jedem jeweils auf die Leiterrahmen ausgerichteten Teil angebracht wird, wobei jede Ausnehmung (280) die Plättchenauflage (56) und die Halbleitervorrichtung (120) sowie einen an das eine Ende jedes Leiters (74 - 77) des entsprechenden Leiterrahmens angrenzenden Abschnitt enthält, und
einkapselnder Kunststoff in fließfähiger Form unter Druck aus einem außerhalb der Form befindlichen Reservoir (120) jeder Ausnehmung zugeführt wird, wobei der Metallstreifen einen Durchgangsweg (300) in Form eines festen Abschnitts aufweist, der von dem mit dem Reservoir (180) verbundenen Hauptangußkanal (185) zu den Ausnehmungen verläuft, so daß dadurch eine der Flächen der Nebenangußkanäle gebildet wird, und der einkapselnde Kunststoff längs der Nebenangußkanäle (240, 245, 265, 270 275) in einem Teil der Form über eine Fläche des Durchgangswegs zu den Ausnehmungen transportiert wird, wobei sich die Nebenangußkanäle von dem Angußkanal (185) zu den Ausnehmungen erstrecken.

## Revendications

1. Appareil pour emballer des dispositifs semi-conducteurs à l'intérieur de boîtiers en plastique d'encapsulage dans lequel une bande de métal substantiellement plate (20) incluant une pluralité de grilles de connexion (40-49) est placée entre deux parties (220, 230) d'un moule (190) ayant des cavités (280) dans chaque partie respectivement alignées avec les grilles de connexion, et un réservoir (180) de matière plastique d'encapsulage sous pression est connecté aux cavités par un canal principal (185) et des sous-canaux (240, 245, 265, 270, 275) formés dans les parties du moule, chaque structure conductrice étant munie d'une plage de connexion en barre (56) ayant un dispositif semi-conducteur (120) fixé à celle-ci et d'une pluralité de conducteurs (74-77), chaque conducteur s'étendant depuis une première extrémité adjacente à la plage de connexion en barre vers une extrémité opposée écartée de la plage de connexion en barre, chaque cavité (280) incluant la plage de connexion en barre (56) et le dispositif semi-conducteur (120) et une partie adjacente à la première extrémité de chaque conducteur (74-77) de la grille de connexion respective, dans lequel la bande de métal inclut une voie de communication (300) sous la forme d'une partie solide qui s'étend depuis le canal principal (185) relié au réservoir (180) vers lesdites cavités, formant ainsi une des surfaces des sous-canaux, et
les sous-canaux (240, 245, 265, 270, 275) recouvrent la voie de communication (300) pour transporter de matière plastique fluide depuis le réservoir (180) via le canal principal (185) sur une surface de la bande (20) des cavités (280).

2. Appareil selon la revendication 1, dans lequel la bande de métal inclut des grilles de connexion sur chaque face de la voie de communication.

3. Procédé d'encapsulage de dispositifs semi-conducteurs à l'intérieur de boîtiers plastiques comprenant :
fournir une bande de métal substantiellement plate (20) incluant une pluralité de grilles de connexion (40-49), chaque grille de connexion étant munie d'une plage de connexion en barre (56) ayant un dispositif semi-conducteur (120) attaché à celle-ci et d'une pluralité de conducteurs (74-77), chaque conducteur s'étendant depuis une première extrémité adjacente à la plage de connexion en barre vers une extrémité opposée écartée de la plage de connexion en barre,
placer la bande de métal entre deux parties (220, 230) d'un moule (190) ayant des cavités (280) dans chaque partie respectivement alignée avec les grilles de connexion, chaque cavité (280) incluant la plage de connexion en barre (56) et le dispositif semi-conducteur (120) et une partie adjacente à la première extrémité de chaque conducteur (74-77), de la grille de connexion respective, et
fournir de la matière plastique d'encapsulage sous une forme fluide sous pression depuis un réservoir (180) externe au moule vers chaque cavité, dans lequel
la bande de métal inclut une voie de communication (300) sous la forme d'une partie solide qui s'étend depuis un canal principal (185) formé dans le moule et relié au réservoir (180) et auxdites cavités, formant ainsi une des surfaces des sous-canaux, et la matière plastique d'encapsulage est convoyée vers les cavités, le long des sous-canaux (240, 245, 265, 270, 275) dans une partie du moule sur une surface de la voie de communication, les sous-canaux s'étendant depuis le canal (185) vers les cavités.
